# EUROPEAN PATENT APPLICATION

(11) **EP 3 965 542 A2**
(43) Date of publication of application: **09.03.2022**
(21) Application number: 21194310.5
(22) Date of filing: 01.09.2021
(51) Int. Cl.: H05K 7/20

(54) **HEAT DISSIPATION SYSTEM AND SERVER SYSTEM**

(30) Priority: 03.09.2020 CN 202010914496
(71) Applicant: Beijing Tusen Zhitu Technology Co., Ltd., Beijing 100016 (CN)
(72) Inventor: Ma, Zhihua, Beijing, 100016 (CN); Hao, Jianan, Beijing, 100016 (CN)
(74) Representative: Murgitroyd & Company

(57) **Abstract**

The present invention discloses a heat dissipation system and a server system for solving the problems that servers have a poor heat dissipation performance and cooling liquid leaks and thus comes into contact with heating components. The heat dissipation system is used for dissipating the heat from a heat-generating element in a case. The heat dissipation system comprises a water-cooling heat dissipation element and a first pipeline set arranged inside the case, and a water-cooling device arranged outside the case. The water-cooling heat dissipation element is coupled to the heat-generating element. The first pipeline set has a first end and a second end. The first end is welded to the water-cooling heat dissipation element. The water-cooling device is connected to the second end. Cooling liquid of the water-cooling device flows through the first pipeline set and the water-cooling heat dissipation element to dissipate heat from the heat-generating element.

## Description

### TECHNICAL FIELD

The present invention relates to the field of autonomous driving, and in particular to a heat dissipation system and a server system.

### BACKGROUND

At present, in order to realize autonomous driving of a vehicle, one or even more vehicle-mounted servers are typically provided for decision-making and control in the autonomous vehicle. Autonomous driving involves complex technologies and thus requires more powerful vehicle-mounted servers, which have great computing powers, high processing efficiencies and long-term operational stability (such as strong vibration resistance and good heat dissipation performance). Therefore, compared to an ordinary server, a vehicle-mounted server requires a larger number of elements to be installed.

Limited by the space of a vehicle, these core elements are generally densely and compactly arranged in a case with limited space. However, some elements (hereinafter referred to as heat-generating elements) will generate heat during the operation, which may cause malfunction of the heat-generating elements as the temperature increases. Therefore, it is necessary to timely dissipate the heat from the heat-generating elements to ensure the normal operation of the core elements. The internal connections of existing water-cooling heat dissipation systems employed in servers in server rooms involve the risk of loosening and thus leaking cooling liquid when operating in running vehicles. Heat-generating elements will be shorted and fail to normally operate if exposed to the leaked cooling liquid, thereby posing a risk to autonomous driving. For this reason, the existing water-cooling radiator architecture provided in servers is not suitable for being used in vehicles.

How to timely and quickly dissipate the heat from vehicle-mounted servers and avoid the risk that cooling liquid leaks and thus comes into contact with heat-generating elements when a dissipation system operates in running vehicles has become a technical problem that needs to be solved urgently by those skilled in the art.

### SUMMARY

The present invention provides a heat dissipation system capable of quickly dissipating the heat from heat-generating elements in servers by water cooling to ensure the stable operation of the heat-generating elements and avoiding the risk that cooling liquid leaks and thus comes into contact with the heat-generating elements when operating in running vehicles.

The present invention provides a server system, wherein a heat dissipation system of the server system is capable of quickly dissipating the heat from heat-generating elements in servers by water cooling to ensure the stable operation of the heat-generating elements and avoiding the risk that cooling liquid leaks and thus comes into contact with the heat-generating elements when operating in running vehicles.

Other aims and advantages of the present invention will be further understood from the technical features disclosed in the present invention.

To achieve one or part or all of the above aims or other aims, an embodiment of the present invention provides a heat dissipation system for dissipating the heat from at least one heat-generating element in a case. The heat dissipation system comprises at least one water-cooling heat dissipation element, a first pipeline set and a water-cooling device. The at least one water-cooling heat dissipation element is arranged inside the case and coupled to at least one heat-generating element. The first pipeline set is arranged inside the case and has a first end and a second end. The first end is welded to the at least one water-cooling heat dissipation element. The water-cooling device is arranged outside the case and connected to the second end. Cooling liquid of the water-cooling device is allowed to flow through the first pipeline set and the at least one water-cooling heat dissipation element to dissipate the heat from the at least one heat-generating element.

In one embodiment of the present invention, the above case comprises a housing. The second end is connected to the water-cooling device through an opening of the housing.

In one embodiment of the present invention, the above at least one water-cooling heat dissipation element is arranged in contact with the at least one heat-generating element to dissipate the heat from the at least one heat-generating element.

In one embodiment of the present invention, the above at least one heat-generating element includes a plurality of heat-generating elements, and the at least one water-cooling heat dissipation element includes a plurality of water-cooling heat dissipation elements. Each of the plurality of heat-generating elements corresponds to at least one of the plurality of water-cooling heat dissipation elements.

In one embodiment of the present invention, the above first pipeline set comprises a plurality of first pipelines. Each of the plurality of water-cooling heat dissipation elements is connected to at least one of the plurality of first pipelines by welding. The cooling liquid is allowed to flow through the plurality of first pipelines and the plurality of water-cooling heat dissipation elements to dissipate the heat from the plurality of heat-generating elements.

In one embodiment of the present invention, the above at least one water-cooling heat dissipation element is connected to the first pipeline set by welding. The cooling liquid is allowed to flow through the first pipeline set and the at least one water-cooling heat dissipation element to dissipate the heat from the at least one heat-generating element. The first pipeline set and the at least one water-cooling heat dissipation element connected thereto by welding provide a sealed flow path for the cooling liquid in the case.

In one embodiment of the present invention, the above first pipeline set comprises a plurality of first pipelines. The plurality of first pipelines are made of a material including copper.

In one embodiment of the present invention, the above water-cooling device comprises a water tank, a water pump, and a second pipeline set. The water tank is used for storing cooling liquid. The water pump is installed on the water tank and used for pressurizing the cooling liquid. The second pipeline set is connected between the water tank and the second end of the first pipeline set. The cooling liquid pressurized by the water pump is allowed to sequentially flow through the second pipeline set and the first pipeline set into the at least one water-cooling heat dissipation element. The cooling liquid from the at least one water-cooling heat dissipation element is allowed to sequentially flow through the first pipeline set and the second pipeline set into the water tank.

In one embodiment of the present invention, the above water-cooling device further comprises a water-cooling radiator for cooling the cooling liquid. The water-cooling radiator is connected between the second end of the first pipeline set and the water tank through the second pipeline set.

In one embodiment of the present invention, the above water-cooling device further comprises a fan set arranged on the water-cooling radiator.

In one embodiment of the present invention, the heat dissipation system further comprises a water distributor. The second pipeline set is connected to the second end of the first pipeline set through the water distributor. The water distributor distributes the cooling liquid from the second pipeline set to the first pipeline set.

In one embodiment of the present invention, the above heat dissipation system further comprises at least one quick connector. The second pipeline set is connected to the water distributor through the at least one quick connector.

In one embodiment of the present invention, the above first pipeline set and the second pipeline set are made of different materials.

In one embodiment of the present invention, the first pipeline set and the second pipeline set have different hardnesses.

In one embodiment of the present invention, the second pipeline set comprises a plurality of hoses.

In one embodiment of the present invention, the above first pipeline set comprises a plurality of first pipelines. Each of the at least one water-cooling heat dissipation element comprises an upper cover, a water-cooling heat dissipation layer, and a bottom plate. The upper cover comprises an inlet hole and an outlet hole, each of which is connected to one of the first pipelines at the first end. The water-cooling heat dissipation layer comprises an internal space. The inlet hole and the outlet hole are connected to the internal space. The cooling liquid is allowed to flow through the inlet hole into the internal space and flow through the outlet hole out of the internal space. The bottom plate comprises a bottom plate opening. The water-cooling heat dissipation layer is arranged between the upper cover and the bottom plate. The water-cooling heat dissipation layer is exposed to the bottom plate opening so as to come into contact with the at least one heat-generating element.

In one embodiment of the present invention, the above internal space comprises a heat sink. The heat sink comprises a plurality of heat dissipation structures. The heat dissipation structures form a plurality of water-cooling flow channels for directing the cooling liquid.

In one embodiment of the present invention, the above at least one heat-generating element includes a central processing unit (CPU) or a graphics processing unit (GPU).

In one embodiment of the present invention, the above at least one heat-generating element is coated with a layer of thermally conductive silicone grease.

To achieve one or part or all of the above aims or other aims, an embodiment of the present invention provides a heat dissipation system for dissipating the heat from a plurality of heat-generating elements in a case. The plurality of heat-generating elements include a CPU or a GPU, and the heat dissipation system comprises a plurality of water-cooling heat dissipation elements, a plurality of metal conduits and a water-cooling device. The plurality of water-cooling heat dissipation elements are arranged inside the case and in contact with the plurality of heat-generating elements. Each of the plurality of water-cooling heat dissipation elements comprises a water-cooling flow channel. The plurality of metal conduits are arranged inside the case and have a first end and a second end. The first end is welded to the plurality of water-cooling heat dissipation elements. The water-cooling device is arranged outside the case. The water-cooling device comprises a water tank, a water pump and a hose set. The water tank is used for storing cooling liquid. The water pump is installed on the water tank and used for pressurizing the cooling liquid. The hose set is connected between the water tank and the second end of the plurality of metal conduits. The cooling liquid pressurized by the water pump is allowed to flow through the plurality of metal conduits and each of the water-cooling flow channels of the plurality of water-cooling heat dissipation elements to dissipate the heat from the plurality of heat-generating elements.

To achieve one or part or all of the above aims or other aims, an embodiment of the present invention provides a server system comprising a case and the above heat dissipation system. The case contains at least one heat-generating element. The heat dissipation system is used for dissipating the heat from the at least one heat-generating element in the case.

To achieve one or part or all of the above aims or other aims, an embodiment of the present invention provides a server system comprising a case and the above heat dissipation system. The case contains a plurality of heat-generating elements. The heat dissipation system is used for dissipating the heat of the plurality of heat-generating elements in the case.

Based on the above, the embodiments of the present invention have at least one of the following advantages or effects. The server system provided in the embodiment of the present invention comprises a heat dissipation system. The heat-generating element, the water-cooling heat dissipation element and the first pipeline set of the heat dissipation system are arranged inside the case, while the water-cooling device is arranged outside the case. The first end of the first pipeline set is welded to the water-cooling heat dissipation element, and the second end of the first pipeline set is connected to the water-cooling device. The cooling liquid of the water-cooling device is allowed to flow through the first pipeline set and the water-cooling heat dissipation element to dissipate the heat from the heat-generating element. Therefore, the heat dissipation system is capable of quickly dissipating the heat from heat-generating elements in servers by water cooling to ensure the stable operation of the heat-generating elements. Besides, the water-cooling device is arranged outside the case, and the first pipeline set is connected to the water-cooling heat dissipation element by welding. Therefore, the heat dissipation system is capable of avoiding the risk that cooling liquid leaks and thus comes into contact with heat-generating elements when operating in running vehicles.

### BRIEF DESCRIPTION OF THE DRAWINGS

The drawings are provided to facilitate a further understanding of the present invention and form a part of the specification, and, together with the embodiments of the present invention, are provided to illustrate the present invention without limiting the present invention.
FIG. 1 is a schematic structural diagram of a server system (with a housing of a case included) in an embodiment of the present invention;
FIG. 2 is a schematic structural diagram of the server system (with the housing of the case omitted) in the embodiment of the present invention in FIG. 1;
FIG. 3 is a top view of the server system (with the housing of the case included) in the embodiment of the present invention in FIG. 1;
FIG. 4 is a top view of the server system (with the housing of the case omitted) in the embodiment of the present invention in FIG. 1;
FIG. 5 is a schematic structural diagram of one water-cooling heat dissipation element and a corresponding first pipeline set in the embodiment of the present invention in FIG. 1;
FIG. 6 is a schematic structural diagram of two water-cooling heat dissipation elements and a corresponding first pipeline set in the embodiment of the present invention in FIG. 1;
FIG. 7 is an exploded view of a water-cooling heat dissipation element and a corresponding heat-generating element in the embodiment of the present invention in FIG. 1;
FIG. 8 is a schematic structural diagram of a water-cooling heat dissipation layer in the embodiment of the present invention in FIG. 7; and
FIG. 9 is a schematic structural diagram of an upper cover in the embodiment of the present invention in FIG. 7.

### DETAILED DESCRIPTION

In order to enable those skilled in the art to better understand the technical schemes of the present invention, the technical schemes in the embodiments of the present invention will be clearly and completely described below with reference to the drawings in the embodiments of the present invention. It is obvious that the described embodiments are only part of the embodiments of the present invention rather than all of the embodiments. All other embodiments obtained by those skilled in the art without making any creative effort based on the embodiments of the present invention shall fall within the protection scope of the present invention.

The heat dissipation system provided in the example of the present invention can be applied to vehicle-mounted servers of autonomous vehicles, servers of unmanned aerial vehicles, servers of autonomous ships, robots and all other servers in need of heat dissipation, and application scenarios are not strictly limited in the present application.

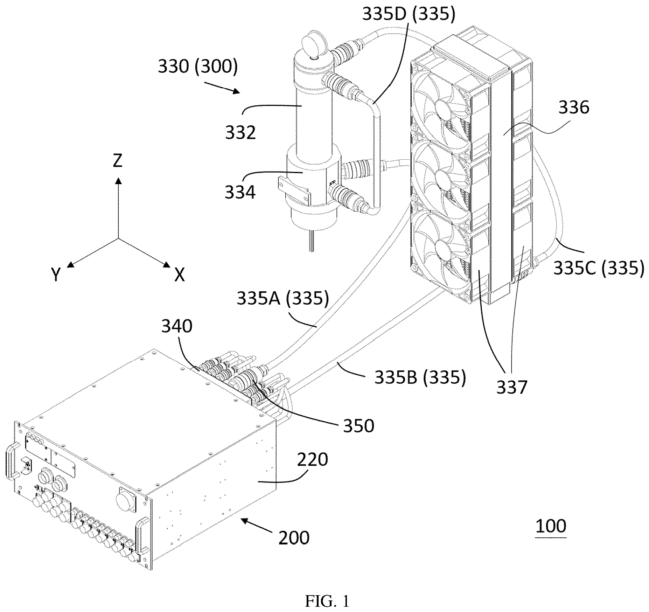

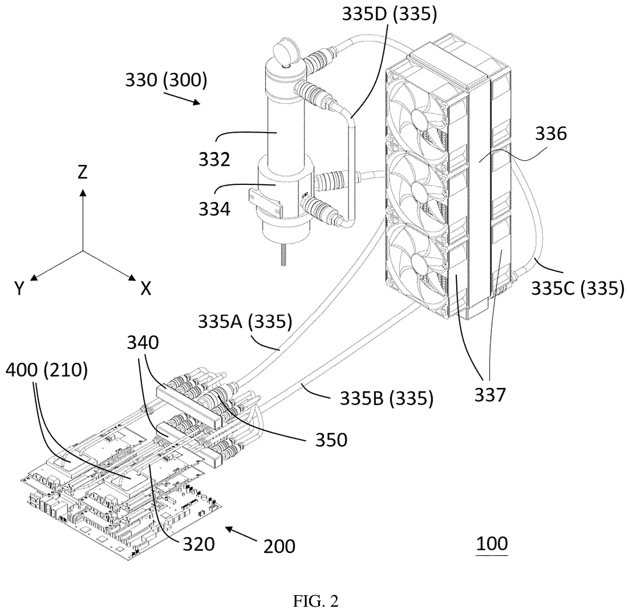

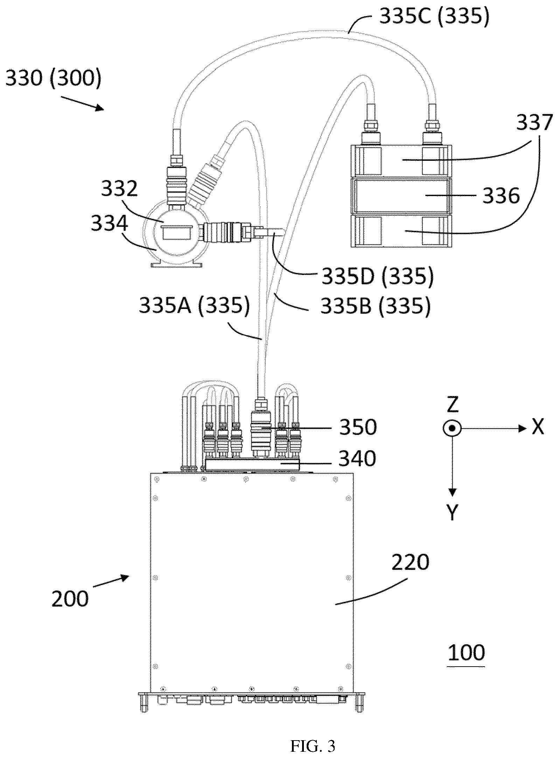

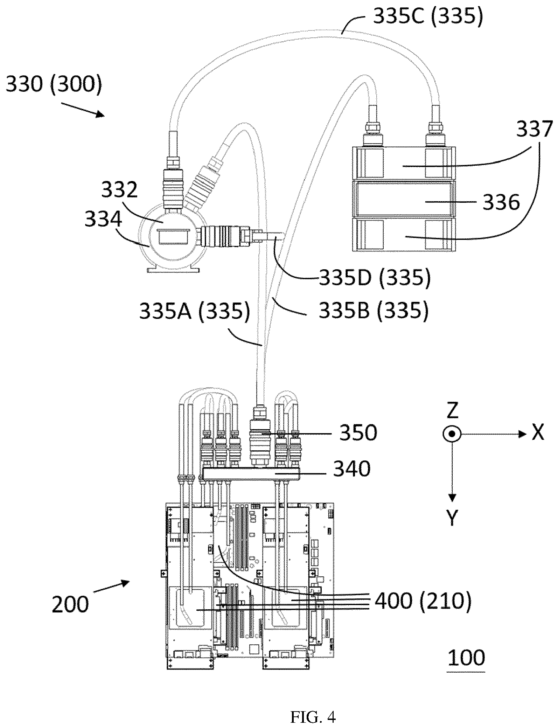

See FIG. 1, FIG. 2, FIG. 3 and FIG. 4. For clear presentation of the elements inside the case 200, the housing 220 of the case 200 is omitted in FIG. 2 and FIG. 4. In this example, a server system 100 is located in, for example, a space defined by a first axis X, a second axis Y and a third axis Z perpendicular to each other. Thus, in this example, the relative positions between the elements in the server system 100 can be more clearly understood. However, the corresponding arrangement of the elements in the server system 100 is only one example of the present invention instead of being a limitation.

In this example, the server system 100 comprises a case 200 and a heat dissipation system 300. The case 200 contains at least one heat-generating element 210, for example, a plurality of heat-generating elements 210 (see FIG. 2 and FIG. 4). The heat-generating elements 210 may include a central processing unit (CPU), a graphics processing unit (GPU), a plurality of expansion cards, a power supply, or other types of heat-generating elements. The case 200 may comprise a housing 220, and the heat-generating elements 210 are arranged, for example, in the housing 220 of the case 200.

The heat dissipation system 300 comprises at least one water-cooling heat dissipation element 400, a first pipeline set 320 and a water-cooling device 330. In this example, the heat dissipation system 300 comprises, for example, a plurality of the water-cooling heat dissipation elements 400. The water-cooling heat dissipation elements 400 and the first pipeline set 320 are arranged inside the case 200. Each of the heat-generating elements 210 may be arranged corresponding to at least one of the water-cooling heat dissipation elements 400. In some examples, the number and types of the heat-generating elements 210 and the water-cooling heat dissipation elements 400 may be provided according to actual requirements. The water-cooling heat dissipation elements 400 may be arranged, for example, in one-to-one correspondence with the heat-generating elements 210, or a plurality of the water-cooling heat dissipation elements 400 may be arranged corresponding to one heat-generating element 210 according to actual requirements, which is not limited by the present invention. One water-cooling heat dissipation element 400 may be provided, for example, in a rectangular or a square shape with the side length being 50 cm, or one water-cooling heat dissipation element 400 is provided in different sizes and shapes according to the size of the heat-generating element 210 and other requirements.

In this example, the water-cooling heat dissipation elements 400 are coupled to at least one heat-generating element 210, for example, the heat-generating elements 210. The water-cooling heat dissipation elements 400 may be arranged, for example, in direct contact with the heat-generating elements 210 to dissipate the heat from the heat-generating elements 210, thereby achieving a better heat dissipation effect. However, in some examples, the water-cooling heat dissipation elements 400 may also be arranged in indirect contact with the heat-generating elements 210, for example, through one or more other elements or coatings, which is not limited by the present invention. Specifically, the heat-generating elements 210 may be coated, for example, with a layer of thermally conductive silicone grease, such that the heat from the heat-generating elements 210 is uniformly directed to the water-cooling heat dissipation elements 400. The heat-generating elements 210 may also be provided with other types of heat dissipation materials according to actual requirements. In addition, the heat-generating elements 210 may also be provided with heat dissipation fins or other heat dissipation elements above, which is not limited by the present invention.

In this example, the first pipeline set 320 has a first end and a second end. The first end is, for example, an end of the first pipeline set 320 in the arrow direction of the second axis Y in FIG. 2, and the second end is, for example, an end of the first pipeline set 320 opposite the arrow direction of the second axis Y in FIG. 2. The first end of the first pipeline set 320 is welded to at least one water-cooling heat dissipation element, for example, the water-cooling heat dissipation elements 400. The second end of the first pipeline set 320 is connected to the water-cooling device 330. The housing 220 may have an opening, and the second end of the first pipeline set 320 is connected to the water-cooling device 330 through the opening of the housing 220.

In this example, the heat dissipation system 300 is used for dissipating the heat from at least one heat-generating element, for example, the heat-generating elements 210, in the case 200. Specifically, the cooling liquid of the water-cooling device 330 is allowed to flow through the first pipeline set 320 and the water-cooling heat dissipation elements 400 to dissipate the heat from the heat-generating elements 210.

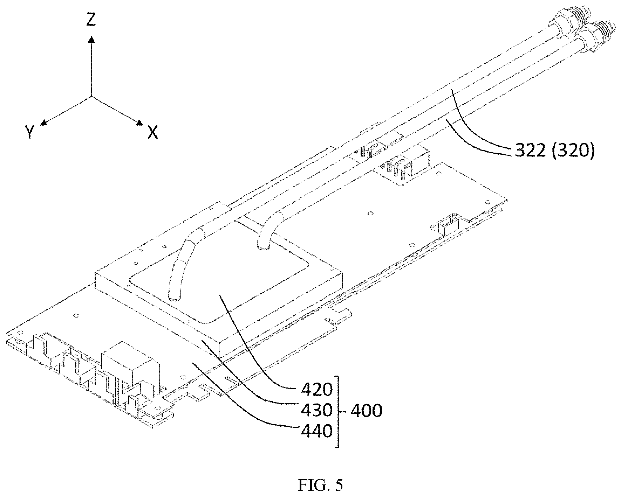

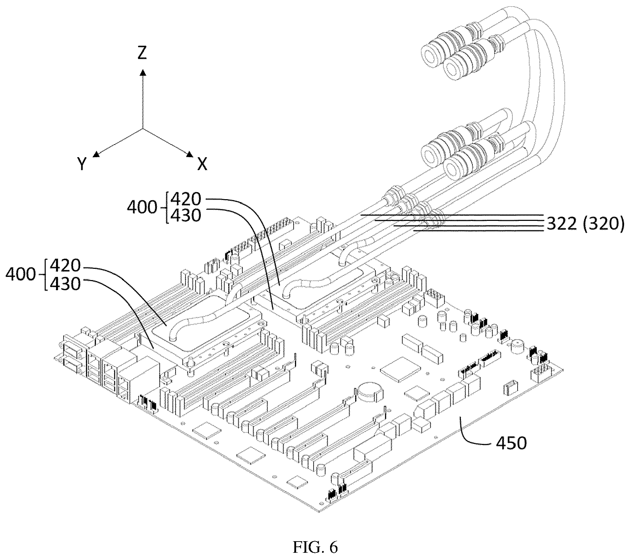

See FIG. 2, FIG. 5 and FIG. 6. In FIG. 5, the heat-generating element 210 corresponding to the water-cooling heat dissipation element 400 is, for example, a GPU, and in FIG. 6, the heat-generating elements 210 corresponding to the water-cooling heat dissipation elements 400 are, for example, CPUs. Specifically, in some examples, the server system 100 may be provided with different numbers of CPUs, GPUs or other types of elements according to actual requirements, and the number and the arrangement of the water-cooling heat dissipation elements 400, and the arrangement of the first pipeline set 320, are correspondingly adjusted, which is not limited by the present invention.

In this example, the first pipeline set 320 comprises a plurality of first pipelines 322. Each of the water-cooling heat dissipation elements 400 is connected to at least one of the first pipelines 322 by welding. The cooling liquid from the water-cooling device 330 is allowed to flow through the first pipelines 322 and the water-cooling heat dissipation elements 400 to dissipate the heat from the heat-generating elements 210. For example, FIG. 5 shows one water-cooling heat dissipation element 400 and two first pipelines 322 connected thereto by welding. However, in other examples, an appropriate number of the first pipelines 322 may be provided to connect to one water-cooling heat dissipation element 400 according to actual requirements. In some examples, the first pipeline 322 may also be fixed to the water-cooling heat dissipation element 400 with a fastener and be connected to the water-cooling heat dissipation element 400. In addition, for example, FIG. 6 shows two water-cooling heat dissipation elements 400 and four first pipelines 322 connected thereto by welding. In addition, the heat-generating elements corresponding to the water-cooling heat dissipation elements 400 are, for example, CPUs, and are arranged on a motherboard 450.

See FIG. 2 and FIG. 4. In this example, the water-cooling device 330 comprises a water tank 332, a water pump 334, a second pipeline set 335, a water-cooling radiator 336 and a fan set 337. The water tank 332 is used for storing cooling liquid, and the water pump 334 is installed on the water tank 332 to pressurize the cooling liquid. The second pipeline set 335 is connected between the water tank 332 and the second end of the first pipeline set 320. Specifically, the cooling liquid pressurized by the water pump 334 is allowed to sequentially flow through the second pipeline set 335 and the first pipeline set 320 into the water-cooling heat dissipation elements 400. The cooling liquid from the water-cooling heat dissipation elements 400 is allowed to sequentially flow through the first pipeline set 320 and the second pipeline set 335 into the water tank 332. In this example, the water-cooling radiator 336 is connected between the second end of the first pipeline set 320 and the water tank 332 through the second pipeline set 335 so as to cool the cooling liquid. The fan set 337 is arranged on the water-cooling radiator 336, for example, so as to achieve a better cooling effect. Specifically, in this example, the fan set 337 may be, for example, two fan walls, as shown in FIG. 1 to FIG. 4, and the water-cooling radiator 336 is arranged between the two fan walls. The arrangement of the fan set 337 and the water-cooling radiator 336 can meet the requirement on the heat dissipation under high power conditions, for example, 1400 watts (W), so as to provide a sufficient wind speed and volume to dissipate the heat from the cooling liquid. However, in some examples, the fan set 337 may also be one or a plurality of fan walls. The number and the arrangement of the fans in the fan set 337 can also be adjusted according to the actual requirement on heat dissipation, which is not limited by the present invention.

In this example, the heat dissipation system 300 further comprises a water distributor 340 and at least one quick connector 350, for example, a plurality of quick connectors 350. The second pipeline set 335 is connected to the water distributor 340 through the quick connectors 350 and to the second end of the first pipeline set 320 through the water distributor 340. Specifically, the water distributor 340 distribute the cooling liquid from the second pipeline set 335 into the first pipeline set 320. By the arrangement of the water distributor 340, the number of the pipelines in the second pipeline set 335 may be, for example, less than or equal to the number of the pipelines in the first pipeline set 320, thereby reducing the number of the pipelines outside the case 200. In addition, by the arrangement of the quick connectors 350, the connection between the first pipeline set 320 and the second pipeline set 335 can be quickly established and adjusted at least according to different server module architectures and requirements on heat dissipation.

See FIG. 2 and FIG. 4. In this example, the second pipeline set 335 comprises a second pipeline 335A, a second pipeline 335B, a second pipeline 335C, and a second pipeline 335D. The second pipeline 335A is connected between the water pump 334 and the first pipeline set 320; the second pipeline 335B is connected between the first pipeline set 320 and the water-cooling radiator 336; the second pipeline 335C is connected between the water-cooling radiator 336 and the water tank 332; the second pipeline 335D is connected between the water tank 332 and the water pump 334. Specifically, the cooling liquid from the water tank 332 is pressurized in the water pump 334 to flow through the second pipeline 335A into the first pipelines 322 of the first pipeline set 320. The cooling liquid is then allowed to flow through the first pipelines 322 and the water-cooling heat dissipation elements 400 to dissipate the heat from the heat-generating elements 210, and to flow through the first pipelines 322 into the second pipeline 335B. The cooling liquid is then allowed to flow through the second pipeline 335B and the water-cooling radiator 336 into the second pipeline 335C, wherein the water-cooling radiator 336 and the fan set 337 further dissipate the heat from the cooling liquid. The cooling liquid flowing into the second pipeline 335C is then allowed to flow back to the water tank 332 for circulation.

In this example, the first pipeline set 320 (the first pipelines 322) and the second pipeline set 335 are made of different materials and have different hardnesses. The first pipelines 322 are, for example, a plurality of metal conduits, which may be made of a material including, for example, copper, or may be made of, for example, metallic or non-metallic materials that facilitate thermal conduction and welding. In this example, the second pipeline 335A, the second pipeline 335B, the second pipeline 335C and the second pipeline 335D may be, for example, bendable hoses for forming hose sets, so that the water tank 332, the water pump 334, the water-cooling radiator 336 and the fan set 337 can be arranged at appropriate positions with respect to the case 200 according to actual requirements.

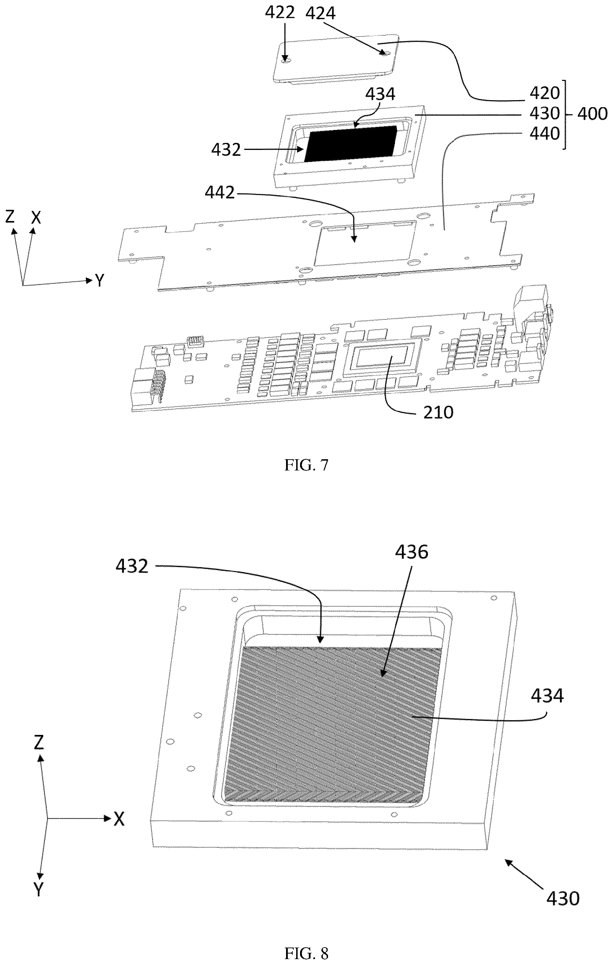

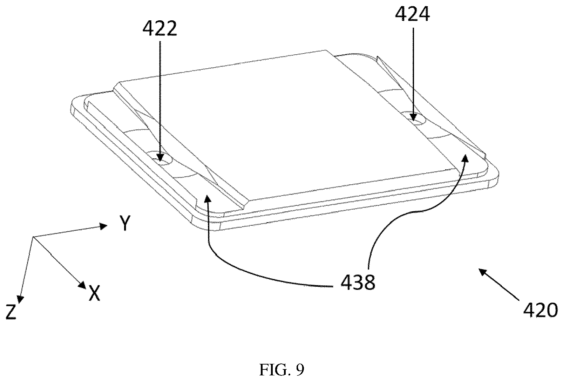

See FIG. 7, FIG. 8 and FIG. 9. In this example, each of the water-cooling heat dissipation elements 400 comprises an upper cover 420, a water-cooling heat dissipation layer 430, and a bottom plate 440. The water-cooling heat dissipation layer 430 is arranged between the upper cover 420 and the bottom plate 440. The bottom plate 440 comprises a bottom plate opening 442. The water-cooling heat dissipation layer 430 is exposed to the bottom plate opening 442 so as to come into contact with at least one heat-generating elements 210, for example, to dissipate the heat from the heat-generating element 210. Specifically, the upper cover 420 comprises an inlet hole 422 and an outlet hole 424 (FIG. 7 and FIG. 9), each of which is connected to one of the first pipelines 322 at the first end of the first pipeline set 320. The water-cooling heat dissipation layer 430 comprises an internal space 432, and the inlet hole 422 and the outlet hole 424 are connected to the internal space 432. The cooling liquid is allowed to flow through the inlet hole 422 into the internal space 432 and flow through the outlet hole 424 out of the internal space 432. In addition, the internal space 432 contains a heat sink 434 comprising a plurality of heat dissipation structures 436. The heat dissipation structures 436 form a plurality of water-cooling flow channels 438 (FIG. 9) for directing the cooling liquid. In this example, the heat from the heat-generating element 210 can be transferred to the heat sink 434 and dissipated through the heat dissipation structures 436. The cooling liquid from the first pipelines 322 is allowed to flow through the inlet holes 422 into the internal space 432 to absorb the heat from the heat sink 434. The cooling liquid is then allowed to flow through the outlet hole 424 out of the internal space 432 and flow through the first pipelines 322 out of the case 200 (for example, to the second pipeline set 335). Specifically, the heat dissipation structures 436 may be, for example, copper slit structures, or other heat dissipation structures, for increasing the heat dissipation surface area, which is not limited by the present invention.

See FIG. 5 to FIG. 9. In this example, the first pipeline set 320 and one water-cooling heat dissipation element 400 or a plurality of water-cooling heat dissipation elements 400 connected thereto by welding provide a sealed flow path for the cooling liquid in the case 200. Specifically, as shown in FIG. 5, at least as the water-cooling heat dissipation element 400 is connected to one or more of the first pipelines 322 by welding, a strong and solid connection is formed at the position of welding to prevent the cooling liquid from leaking through the connection and thus provide a sealed flow path for the cooling liquid. When the cooling liquid from the second pipeline set 335 (for example, the second pipeline 335A) flows into the case 200 and flows through the first pipeline set 322 to the water-cooling heat dissipation element 400, the cooling liquid is allowed to flow through only the sealed flow path formed from the first pipeline 322 and the water-cooling heat dissipation element 400 without leaking through the connection between the first pipeline 322 and the water-cooling heat dissipation element 400 or other positions.

In this example, the server system 100 comprises a heat dissipation system 300. The heat-generating elements 210, the water-cooling heat dissipation elements 400, and the first pipeline set 320 of the heat dissipation system 300 are arranged inside the case 200, while the water-cooling device 330 is arranged outside the case 200. The first end of the first pipeline set 320 is welded to the water-cooling heat dissipation elements 400, and the second end of the first pipeline set 320 is connected to the water-cooling device 330. The cooling liquid of the water-cooling device 330 is allowed to flow through the first pipeline set 320 and the water-cooling heat dissipation elements 400 to dissipate the heat from the heat-generating elements 210. Therefore, the heat dissipation system is capable of quickly dissipating the heat from the heat-generating elements 210 in servers by water cooling to ensure the stable operation of the heat-generating elements 210. In addition, compared to an air-cooling heat dissipation system, a water-cooling heat dissipation system features a smaller size and lower noise.

Specifically, the water-cooling device 330 is arranged outside the case 200, and the first pipeline set 320 is connected to the water-cooling heat dissipation element 400 by welding. Since the heat-generating elements 210 are isolated from the water-cooling device 330, in some cases where some server systems 100 are operated, e.g., in running vehicles or other environments with vibration, when the cooling liquid of the water-cooling device 330 leaks, e.g., out of the connections of the water tank 332, the water pump 334, the water-cooling radiator 336, the fan set 337 or the second pipeline set 335, it can be blocked by the case 200 (for example, the housing 220 of the case 200) and thus prevented from contacting the heat-generating elements 210. In addition, in this example, the heat-generating elements 210, the water-cooling heat dissipation elements 400 and the first pipelines 322 are connected together, for example, by welding, so as to form a sealed whole in the case 200. For example, the water-cooling heat dissipation elements 400 and the first pipelines 322 can provide a sealed flow path for the cooling liquid in the case 200. In some cases where some server systems 100 are operated, e.g., in running vehicles or other environments with vibration, leakage of the cooling liquid is prevented in the case 200. In other words, the server system 100 and the heat dissipation system 300 thereof can avoid the risk that the cooling liquid leaks and thus comes into contact with the heat-generating elements 210 when operating in running vehicles, and helps to reduce the risk that the heat-generating elements are shorted or fail to normally operate, thereby reducing the risk posed on autonomous driving and improving the stability of autonomous driving.

While the above examples of the present invention have been described, additional variations and modifications can be made to those examples by those skilled in the art once they learn of the basic inventive concepts. Therefore, the accompanying claims are intended to be interpreted as including the above examples and all variations and modifications that fall within the scope of the present invention.

It will be apparent to those skilled in the art that variations and modifications may be made to the present invention without departing from the scope of the present invention. Thus, if such modifications and variations of the present invention fall within the scope of the claims of the present invention and the equivalents thereof, the present invention is intended to include such modifications and variations as well.

## Claims

1. A heat dissipation system for dissipating heat from at least one heat-generating element in a case, comprising:
at least one heat dissipation element arranged inside the case and coupled to the at least one heat-generating element;
a first pipeline set arranged inside the case and having a first end and a second end, wherein the first end is connected to the at least one heat dissipation element; and
a cooling device arranged outside the case and connected to the second end, and configured to facilitate cooling liquid from the cooling device flow through the first pipeline set and the at least one heat dissipation element to dissipate heat from the at least one heat-generating element.

2. The heat dissipation system according to claim 1, wherein the case comprises a housing, wherein the second end is connected to the cooling device through an opening of the housing.

3. The heat dissipation system according to claim 1 or claim 2, wherein the at least one heat dissipation element is arranged in contact with the at least one heat-generating element to dissipate heat from the at least one heat-generating element.

4. The heat dissipation system according to any one of claims 1-3, wherein the at least one heat-generating element includes a plurality of heat-generating elements, and the at least one heat dissipation element includes a plurality of heat dissipation elements, wherein each of the plurality of heat-generating elements corresponds to at least one of the plurality of heat dissipation elements.

5. The heat dissipation system according to claim 4, wherein the first pipeline set comprises a plurality of first pipelines, and each of the plurality of heat dissipation elements is connected to at least one of the plurality of first pipelines, and the cooling device is configured to facilitate the cooling liquid to flow through the plurality of first pipelines and the plurality of heat dissipation elements to dissipate heat from the plurality of heat-generating elements.

6. The heat dissipation system according to any one of claims 1-5, wherein the at least one heat dissipation element is connected to the first pipeline set, and the cooling device is configured to facilitate the cooling liquid to flow through the first pipeline set and the at least one heat dissipation element to dissipate heat from the at least one heat-generating element, wherein the first pipeline set and the at least one heat dissipation element connected thereto provide a sealed flow path for the cooling liquid in the case.

7. The heat dissipation system according to claim 1, wherein the first pipeline set comprises a plurality of first pipelines, and the plurality of first pipelines are made of a material including copper.

8. The heat dissipation system according to any one of claims 1-7, wherein the cooling device comprises:
a tank for storing the cooling liquid;
a pump installed on the tank and for pressurizing the cooling liquid; and
a second pipeline set connected between the tank and the second end of the first pipeline set; wherein:
the cooling liquid is pressurized by the pump to sequentially flow through the second pipeline set and the first pipeline set into the at least one heat dissipation element; and
the pump is configured to facilitate the cooling liquid from the at least one heat dissipation element to sequentially flow through the first pipeline set and the second pipeline set into the tank.

9. The heat dissipation system according to claim 8, wherein the cooling device further comprises:
a radiator for cooling the cooling liquid, and the radiator is connected between the second end of the first pipeline set and the tank through the second pipeline set; and
a fan set arranged on the radiator.

10. The heat dissipation system according to claim 8, further comprising:
a distributor, wherein the second pipeline set is connected to the second end of the first pipeline set though the distributor which distributes the cooling liquid from the second pipeline set to the first pipeline set; and
at least one connector, wherein the second pipeline set is connected to the distributor through the at least one connector.

11. The heat dissipation system according to claim 8, wherein:
the second pipeline set comprises a plurality of hoses;
the first pipeline set and the second pipeline set are made of different materials or have different hardnesses.

12. The heat dissipation system according to any one of claims 1-11 wherein the first pipeline set comprises a plurality of first pipelines, and each of the at least one heat dissipation element comprises:
an upper cover comprising an inlet hole and an outlet hole, each of which is connected to one of the first pipelines at the first end;
a heat dissipation layer comprising an internal space, wherein the inlet hole and the outlet hole are connected to the internal space, and the cooling device is configured to facilitate the cooling liquid to flow through the inlet hole into the internal space and flow through the outlet hole out of the internal space; and
a bottom plate comprising a bottom plate opening.

13. The heat dissipation system according to claim 12, wherein:
the heat dissipation layer is arranged between the upper cover and the bottom plate, and is exposed to the bottom plate opening so as to come into contact with the at least one heat-generating element; and
the internal space contains a heat sink comprising a plurality of heat dissipation structures which form a plurality of channels for the cooling liquid to flow.

14. The heat dissipation system according to any one of claims 1-13, wherein:
the at least one heat-generating element includes at least one central processing unit or at least one graphics processing unit; or
the at least one heat-generating element is coated with a layer of thermally conductive silicone grease.

15. A server system, comprising:
a case containing at least one heat-generating element; and
the heat dissipation system according to any one of claims 1 to 14 for dissipating heat from the at least one heat-generating element in the case.
